# EUROPEAN PATENT APPLICATION

(11) **EP 2 284 868 A1**
(43) Date of publication of application: **16.02.2011**
(21) Application number: 09251955.2
(22) Date of filing: 07.08.2009
(51) Int. Cl.: H01L 21/20, H01L 21/02

(54) **Heterostructure**

(71) Applicant: NXP B.V., 5656 AG Eindhoven (NL); Interuniversitair Microelektronica Centrum vzw, 3001 Leuven (BE)
(72) Inventor: Madakasira, Vijayaraghavan, Redhill, Surrey RH1 1DL (GB); Cantoro, Mirco, Redhill, Surrey RH1 1DL (GB)
(74) Representative: Burton, Nick

(57) **Abstract**

A heterostructure comprising a substrate formed from a first material and having a first lattice parameter and a device component comprising a second material having a second lattice parameter, the first and second lattice parameters being different to one another, the heterostructure further comprising a dielectric layer formed from a third material, extending over the substrate and comprising a opening extending from the substrate through the first layer, the device component comprising a first portion extending through the opening and a second lateral portion extending from the first portion along the dielectric layer.

## Description

This invention relates to a heterostructure, and particularly, but not exclusively to a heterostructure comprising heteroepitaxy layers having different lattice parameters, and to a method of manufacturing such a heterostructure.

Such heterostructures have many applications, and for example are very important in the area of silicon based optoelectronics.

According to a first aspect of the present invention there is provided a heterostructure comprising a substrate formed from a first material and having a first lattice parameter and a device component comprising a second material having a second lattice parameter, the first and second lattice parameters being different to one another, the heterostructure further comprising a dielectric layer formed from a third material, extending across the substrate and comprising an opening extending from the substrate through the first layer, the device component comprising a first portion extending through the opening and a second, lateral portion extending from the first portion along the dielectric layer.

By means of the present invention, the first portion of the device component serves as a seed site to enable lateral growth to take place to form the lateral portion. By means of the present invention therefore it is possible to create a heterolayer formed from the second material which is connected to the substrate formed from the first material, since the lateral portion of the device component is connected to the substrate by means of the first portion of the device substrate.

Still further, because the lateral portion of the device component extends along the dielectric layer it is physically supported by the dielectric layer. In addition, the device component may ultimately form part of a larger device. This larger device may be isolated from other similar devices that may be formed on the same substrate. Still further, by appropriate patterning of the lateral portion in a known manner, portions of the lateral portion may be isolated from the substrate.

The dielectric layer may extend over a surface of the substrate and may have a surface which is spaced apart from the surface of the substrate by the thickness of the dielectric layer.

The opening may thus extend from the surface of the substrate to the surface of the dielectric layer and may have any convenient orientation within the dielectric layer. Preferably, the opening has an axis which extends substantially perpendicularly from the first surface of the substrate.

The first portion of the device component may comprise a nanowire. This means that the opening preferably has a cross-section which is the order of several nanometres. The cross-section of the opening may be up to 70 nm, for example.

The dimensions of the opening are determined by both the thickness of the dielectric layer, the limit determined by the resolution of the patterning technique used to pattern features on the dielectric layer (e.g. optical lithography, to expose features on the optical resist deposited on the dielectric), and the limit determined by the resolution of the etching technique (e.g. plasma etching, to remove dielectric material from the patterned areas and thus expose the substrate in the openings).

In practice, the thinner the dielectric layer used, the smaller the dimension of the opening that can be achieved. It can be advantageous to have a small opening since this reduces the stress at the interface between a nanowire and the substrate. This is because there is a small area of contact between the second material and the substrate. Since the second material and the substrate have different lattice parameters, this small area of contact reduces the stress in both the substrate and the second material. It also promotes a more defect free growth of the component of the device component to the first portion of the device component which extends through the dielectric layer.

The nanowire may extend through the opening from the substrate and may comprise an end portion which extends beyond the dielectric layer. The length of the first portion is thus greater than the thickness of the dielectric layer. The difference between the thickness of the dielectric layer and the length of the device component determines the length of the end portion.

The length of the end portion of the device component in turn defines the thickness of heterolayer formed by the lateral portion of the device component.

The lateral portion extends from the end portion of the nanowire along the surface of the dielectric layer and may serve as a platform for further device fabrication (e.g. by means of patterning and subsequent microfabrication steps) and on which other components forming the device may be integrated.

Since the end portion of the nanowire extends beyond the dielectric layer, the dielectric layer no longer restricts growth of the second material, and therefore the second material is able to grow laterally along the surface of the dielectric layer to form the heterolayer.

The heterostructure may comprise a plurality of openings and a plurality of device components, each device component being located in a respective opening.

A heterostructure according to this embodiment thus comprises a plurality of device components, each device component comprising a first portion comprising a nanowire located in an opening, and a second portion comprising a lateral portion extending from the end portion over a surface of the dielectric layer.

Each lateral portion may be dimensioned such that it does not come into contact with any other lateral portion. In such an embodiment, the lateral portions of the device components comprise islands formed on the dielectric layer.

In an alternative embodiment, the lateral portions are sized and shaped such that each lateral portion is contiguous with adjacent lateral portions such that the lateral portions together form a continuous layer of second material on the dielectric layer.

The pitch of the openings will also determine whether or not the lateral portions comprise discrete islands isolated from other lateral portions forming part of the heterostructure. Thus the size and shape of the lateral portions together with the pitch of the openings formed in the dielectric layer determine whether or not the lateral portions will form a continuous layer on the dielectric layer, or will form discrete islands on the dielectric layer.

In embodiments of the invention comprising a continuous layer of second material, the pitch of the openings may be less than 1 µm.

The substrate may comprise silicon, or another indirect bandgap semiconducting material (e.g. germanium). In such an embodiment, the second material may comprise a III-V based material.

Such a structure will allow integration of LEDs made out of direct bandgap III-V based materials on a silicon or germanium substrate.

Alternatively, the second material may comprise germanium for example. Such embodiments of the invention may be used to produce very fast detectors for optoelectronic modulators.

In other embodiments, the substrate may comprise a III-V material, and the second material may comprise silicon. Such a structure may have application in electro-optics based on silicon very large scale integration.

The third material may comprise silicon oxide.

A (111)-oriented III-V material in the form of a nanowire may be grown on a silicon substrate. The growth of the nanowire depends on parameters such as the chamber pressure in which the growth is taking place, the group-III and -V precursor's partial pressures, the growth temperature, the substrate surface preparation etc.

The formation dynamics of the crystal facets of the III-V material is sensitive to the rate at which the group-III and -V species land on the substrate and begin to form nucleation sites. It is therefore possible to control the crystal growth rate in different crystalline directions with accuracy.

It is further known to grow nanowires formed from GaAs in a vertical (111) direction on a (111)-oriented GaAs substrate and then to achieve lateral growth of the nanowire by changing the growth temperature and the group-III and -V precursors partial pressures using a non-catalytic technique.

In the case of the present invention it is possible to grow GaAs on a silicon substrate for example by initially growing a nanowire along the (111) direction by decreasing the partial pressure of TBAs (tertiary butyl arsine, group-V precursor). This has the effect of suppressing/minimising lateral growth of the GaAs.

By increasing the partial pressure of TBAs, the formation of stable As trimers on As-terminated (111) planes will hinder growth along the vertical (111) direction and favour growth along lateral directions. However at lower partial pressures the As trimers are less stable and therefore vertical growth will not be suppressed in favour of lateral growth.

This effect is not substrate dependent and can be exploited to promote growth direction control of many III-V materials on lattice mismatched substrates. Clearly, if different III-V materials are being used, then the precursors used will be appropriate for the particular III-V material.

According to the invention the end portion of the nanowire that protrudes from the dielectric layer may be used as a seed to grow the lateral portion of the device component directly onto a surface of the dielectric layer. This has the advantage, as stated above that the lateral portion may not only be isolated from other lateral portions formed on the substrate, but portions of the lateral portion may themselves be isolated from the substrate after being subjected to appropriate patterning.

By means of the present invention therefore not only is crystalline stress reduced due to the small contact area between the first material forming the substrate and the second material forming the device component, it is possible to readily isolate the device components from one another and to isolate parts of those device components from the substrate where necessary.

According to a second aspect of the present invention there is provided a method of forming a heterostructure comprising a first material having a first lattice parameter and a device component comprising a second material having a second lattice parameter, the first and second lattice parameters being different to one another, the method comprising the steps of:
(i) forming a dielectric layer on a substrate formed from a first material;
(ii) forming an opening in the dielectric layer extending through the first layer;
(iii) growing the second material in the opening until an end portion of the second material extends from the dielectric layer;
(iv) growing a lateral portion of second material from the end portion.

The first material may comprise silicon or another semiconducting material (e.g. germanium), and the second material may comprise a III-V material. Alternatively, the first material may comprise a III-V material and the second material may comprise silicon or germanium.

The third material may comprise silicon oxide.

The dielectric layer may be formed on the substrate using any convenient technique and for example it may be deposited on a substrate by physical vapour deposition.

The opening in the dielectric may be formed using any appropriate technique and may for example be formed by (dry or wet) etching of the dielectric layer.

The method may comprise the further step of patterning the first layer with a catalyst in the opening prior to growing the second material in the opening.

This step may be necessary if catalytic growth methods are to be used to form the device component.

The method may comprise the step of forming a plurality of openings extending through the first layer, and growing second material in each of the openings. In such an embodiment of the invention, the step of patterning the first layer with a catalyst will comprise the step of patterning the first layer with a catalyst in each opening.

Step (iv) may comprise growing the lateral portions until they form a continuous layer over the first layer. Alternatively, the growth of the lateral portions may be controlled such that each lateral portion comprises an island separate from other lateral portions.

In embodiments of the invention in which the method comprises the step of patterning the first layer with a catalyst, the method may comprise the further step after growth of the lateral portions of removing the catalyst.

The method may comprise a further step of annealing the heterostructure once the lateral portions have been formed. This facilitates the formation of a continuous defect free layer formed from the second material.

According to a third aspect of the present invention there is provided a device component comprising a first portion extending through an opening in a dielectric material to make contact with a substrate, and a second, lateral portion extending from the first portion along a surface of the dielectric layer, the device component being formed from a material having a lattice parameter that is different to that of the material forming a substrate.

The first portion of the device component may comprise a nanowire.

According to a fourth aspect of the present invention there is provided a plurality of device components according to the third aspect of the invention, which device components are isolated from one another.

The invention will now be described by way of example only with reference to the accompanying drawings in which:
Figure 1 is a schematic representation of a heterostructure according to a first embodiment of a present invention;
Figure 2 is a schematic representation of a heterostructure according to a second embodiment in the invention;
Figure 3 is a detailed representation of a portion of the structure of Figure 2 which has been further fabricated to form a device; and
Figures 4 to 9 are schematic representations of one way of forming the structure of Figure 1.

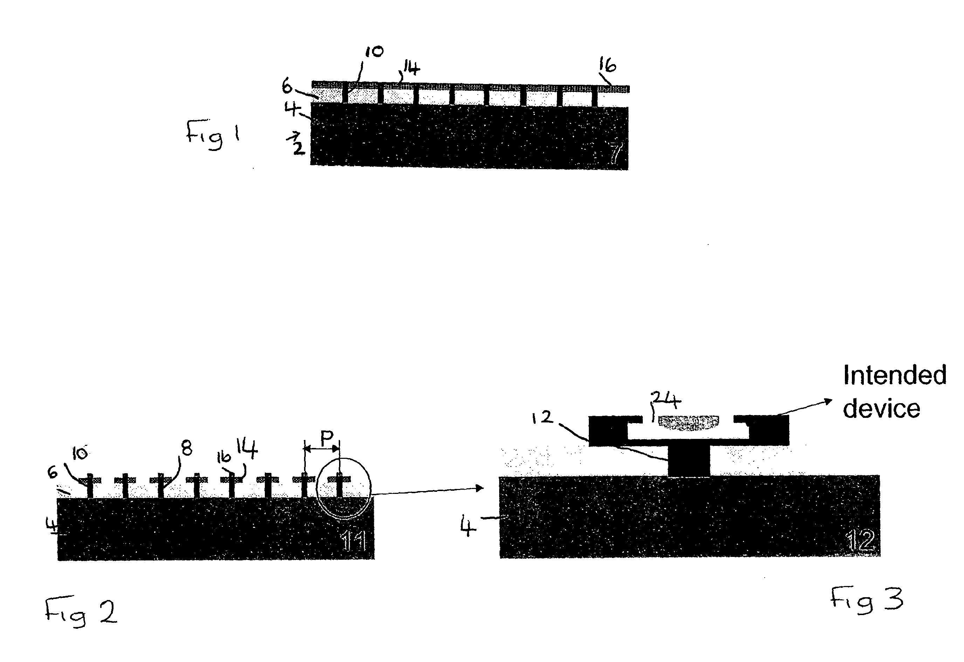

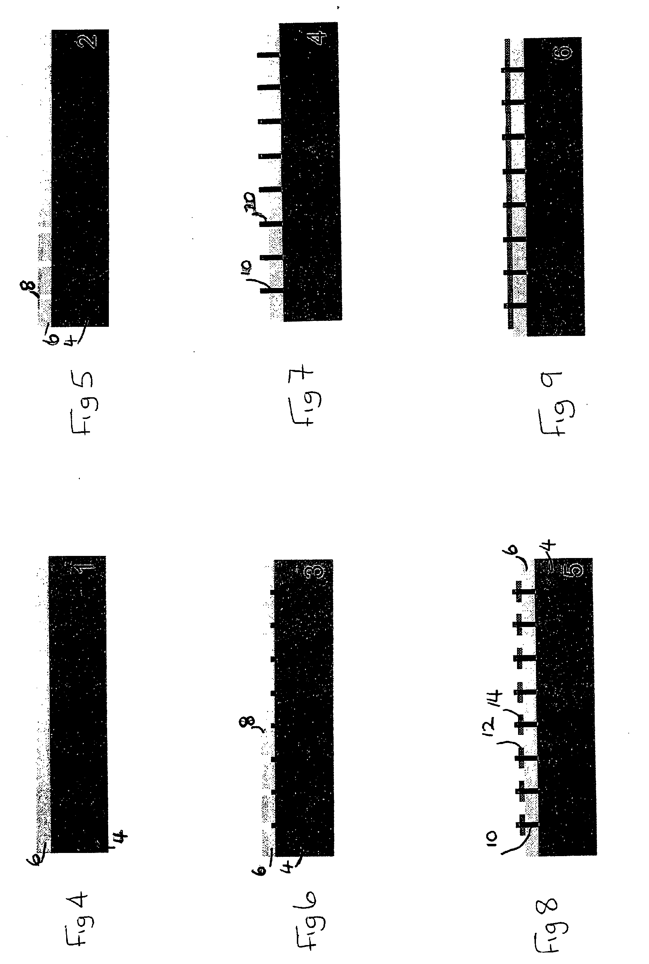

Referring to the Figures 1 and 4 to 9, a heterostructure according to a first embodiment of the present invention is designated generally by the reference numeral 2. The heterostructure 2 comprises a silicon substrate 4, and a dielectric layer 6 formed from silicon oxide and deposited over the substrate 4. The layer 6 comprise a plurality of openings 8 extending through the layer 6 (shown more clearly in Figure 6). The heterostructure 2 further comprises a plurality of nanowires 10 formed from a III-V material such as GaAs each located in a respective opening 8.

Each nanowire 10 forms part of a device component 12, which device component 12 further comprises a lateral portion 14. Each lateral portion 14 may be regarded as an extension of a corresponding nanowire 10 and is thus formed from the same material as the corresponding nanowire 10.

In the embodiment illustrated in Figure 1, the lateral portions 14 associated with each nanowire 10 have merged to form a continuous layer 16.

The structure 2 therefore comprises a III-V material 10, 14 which has been grown directly on a silicon substrate 4.

Such a structure can be used for example for the integration of very fast detectors for optoelectronic modulators in case the III-V material has direct bandgap.

Referring to now Figures 4 to 9, a method of fabricating the structure 2 illustrated in Figure 1 will now be described.

Initially, a silicon substrate 4 is coated with a first layer 6 in the form of silicon oxide as shown in Figure 4. The layer 6 is then patterned with openings 10 formed at predetermined positions in the layer 6 (Figure 5).

The dielectric is then patterned with a catalyst 18 by electrochemical deposition such that there is a catalyst 18 in each opening 8 (Figure 6). In other embodiments, the catalyst may be deposited onto the substrate by other methods (e.g. physical vapor deposition-based methods such as sputtering, thermal evaporation, or flown onto the substrate *in-situ* prior to nanowire growth). The catalyst may be one of a range of compatible materials such as nickel and gold.

The catalyst may be either a foreign or a non-foreign catalyst. A catalyst which is foreign to the particular III-V material is formed from a material that is not the same as either of the components of the III-V material. On the other hand, a non-foreign catalyst is formed from one of the components of the III-V material and typically from the group III material. For example when growing InAs, In catalyst is not foreign. It may be preferable to use a non-foreign catalyst since this simplifies the growth as less materials are introduced into the process as a whole and to avoid the foreign catalyst remaining incorporated into the III-V structure as unwanted impurity/contaminant with potential detrimental effects on the final device performance.

It is not always necessary to use a catalyst in order to grow the nanowires 10. For example if non-catalytic methods are used to form the heterostructure, then it will not be necessary to use a catalyst. This step is not needed, however, if non-catalytic methods are used to form the heterostructure 2.

As shown in Figure 7, controlled growth of the second material then takes place such that nanowires 10 are formed in the openings 8.

In this embodiment, growth of the nanowires 10 is restricted to growth substantially along the (111) direction because of the dimensions and orientation of the openings in which growth occurs. In other embodiments of the invention, the nanowire growth may be restricted to a different direction. Generally, the growth will be restricted to vertical growth on a (100) surface.

Further, growth along (111) direction may be assisted by reducing the partial pressures of the precursors, and particularly the partial pressure of the group-V precursor (e.g. TBAs).

In this example GaAs nanowire growth was carried out at 760°C for 30 minutes. The partial pressures of the group-III and -V precursors (diluted in H₂) were as follows:
[TMGa]=1.4E-07 atm
[TBAs]=3.6E-05 atm

In this example the V/III ratio is 259.

The conditions and ratio set out above are understood to be for illustrative purposes only. In other embodiments of the invention, different growth conditions may prevail.

Once each nanowire 10 has attained a desired length such that an end portion 20 of suitable length of each nanowire extends above the dielectric layer (Figure 7), conditions are modified in order to assist lateral growth.

In particular, the partial pressure of the group-V precursor is increased (e.g. TBAs). This encourages formation and stable As trimers on As-terminated (111) planes which in turn hinders growth along the (111) direction.

In other embodiments, different precursors will be used, as appropriate.

Once lateral growth has begun, the lateral portions 14 will form discrete islands which are separate to any other lateral portion as shown in Figure 8.

If desired, lateral growth can continue until the lateral portions merge together to form a continuous layer as shown in Figure 9. However, there can be problems caused by antiphase boundaries which may form at the point where two lateral portions meet. If this is the case, then it may be desirable to stop lateral growth whilst the lateral portions are still in the form of discrete islands as shown in Figure 8. If it is desired to produce discrete islands as shown in Figure 8 then it may also be desirable to increase the pitch between the nanowires in order to prevent merging of adjacent lateral portions.

The nanowires 10 which in this embodiment comprise GaAs are then grown in a controlled manner from each catalyst 18 until the end portion 20 extends a predetermined distance beyond of the layer 6. The extent that each end portion 20 extends above the layer 6 determines the thickness of the layer 10 which will ultimately be formed.

The growth method is then switched from longitudinal to transverse as shown in Figure 8. The end portion 20 acts as a seed layer, so that lateral portions 14 are formed that extend from the nanowires 10. In this embodiment the lateral portions form islands 22.

If transverse growth is continued, the islands 22 connect with one another to form a continuous layer 16 of III-V material on the silicon oxide.

Finally, the catalyst particles 14 (in the case of the catalytic growth) are removed and the substrate is then annealed to obtain a continuous, defect free III-V layer as shown in Figure 1.

One problem that may be encountered with the structure as illustrated in Figure 1 is that antiphase boundaries may be formed between the adjacent islands 18 where those islands meet.

One way of overcoming this problem is to prevent growth of the islands to such an extent that they contact one another. This may be achieved by, for example, increasing the pitch between the adjacent nanowires 10 to a large enough value such that each individual island 22 may be large enough to accommodate a device 24 as shown in Figures 2 and 3. In an embodiment where the lateral size of the islands is required to be 500 nm for example, the pitch of the nanowires may be than 1 um.

It is necessary to add a catalyst 14 in the present embodiment, because the material 2 is formed using catalytic-methods. However, if other methods are used, then it may not be necessary to add a catalyst component

By means of the present invention it is possible to form a device component which is connected to a substrate such as a silicon substrate in a manner that reduces crystalline stress. Further, by means of the invention it is possible to form a plurality of such device components each connected to a substrate, and each isolated from other similar device components by means of the dielectric layer on which the device components are formed. Still further, the dielectric layer provides a physical support for the lateral portion of the device components.

Finally, by suitable patterning of the lateral portions of the device components, portions of the device components may themselves be isolated from the substrate.

## Claims

1. A heterostructure (2) comprising a substrate (4) formed from a first material and having a first lattice parameter and a device component comprising a second material having a second lattice parameter, the first and second lattice parameters being different to one another, the heterostructure further comprising a dielectric layer (6) formed from a third material, extending over the substrate and comprising a opening (8) extending from the substrate through the first layer, the device component comprising a first portion extending through the opening and a second lateral portion (14) extending from the first portion along the dielectric layer.

2. A heterostructure according to Claim 1 wherein the first portion of the device component comprises a nanowire (10) extending from the substrate through the opening, the nanowire having an end portion (20) extending beyond the dielectric layer.

3. A heterostructure according to Claim 2 wherein the lateral portion (14) extends along the surface of the dielectric layer from the end portion of the nanowire.

4. A heterostructure according to any one of the preceding claims wherein the dielectric layer comprises a plurality of openings (8), and a plurality of device components (10), each device component being located in a respective opening.

5. A heterostructure according to Claim 4 wherein the lateral portion of each component comprises an island (22) formed on the dielectric layer.

6. A heterostructure according to Claim 4 wherein the lateral portions of the components together form a continuous layer on the dielectric layer.

7. A method of forming a heterostructure comprising a substrate (4) formed from first material having a first lattice parameter and a device component (10) comprising a second material having a second lattice parameter, the first and second lattice parameters being different to one another, the method comprising the steps of:
(i) depositing a dielectric layer (6) on the substrate;
(ii) etching the dielectric layer to form a opening (8) extending through the first layer;
(iii) growing the second material in the opening until an end portion (22) of the second material extends from the dielectric layer;
(iv) growing a lateral portion (14) of second material from end portion.

8. A method according to Claim 7 comprising the additional step of patterning the first layer with a catalyst (18) in the opening prior to growing the second material in the opening.

9. A method according to Claim 7 or Claim 8 comprising the step of forming a plurality of openings extending through the first layer, and growing second material in each of the openings.

10. A method according to Claim 9 when dependent upon Claim 8 wherein, the additional step of patterning the first layer with a catalyst in the opening prior to growing the second material in the opening comprises the step of patterning the first layer with a catalyst in each opening.

11. A method according to any one of Claims 7 to 10 wherein step (iv) comprises growing the lateral portions until they form a continuous layer over the first layer.

12. A method according to any one of Claims 7 to 10 wherein step (iv) comprises limiting the growth of the lateral portions such that each lateral portion comprises an island separate from other lateral portions.

13. A device component comprising a first portion extending through an opening in a dielectric material to make contact with a substrate, and a second, lateral portion extending from the first portion along a surface of the dielectric layer, the device component being formed from a material having a lattice parameter that is different to that of the material forming a substrate.
